(19) **Europäisches Patentamt / European Patent Office / Office européen des brevets**

(11) **EP 4 644 509 A1**

(12) **EUROPEAN PATENT APPLICATION**
published in accordance with Art. 153(4) EPC

(43) Date of publication:
**05.11.2025 Bulletin 2025/45**

(21) Application number: **23912696.4**

(22) Date of filing: **14.12.2023**

(51) International Patent Classification (IPC):
**C09K 11/70** $^{(2006.01)}$   **C09K 11/62** $^{(2006.01)}$
**C09K 11/02** $^{(2006.01)}$   **B82Y 20/00** $^{(2011.01)}$
**B82Y 40/00** $^{(2011.01)}$

(52) Cooperative Patent Classification (CPC):
**C09K 11/70; C09K 11/02; C09K 11/025;**
**C09K 11/565; C09K 11/623; C09K 11/883;**
**H10K 50/115;** B82Y 20/00; B82Y 30/00; B82Y 40/00

(86) International application number:
**PCT/KR2023/020653**

(87) International publication number:
**WO 2024/144021 (04.07.2024 Gazette 2024/27)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **29.12.2022 KR 20220189734**

(71) Applicant: **Samsung Display Co., Ltd.**
**Yongin-si, Gyeonggi-do 17113 (KR)**

(72) Inventors:
• **PARK, Seung Won**
**Yongin-Si Gyeonggi-do 17113 (KR)**

• **KIM, Sung Jae**
**Yongin-Si Gyeonggi-do 17113 (KR)**
• **KIM, Young Sik**
**Yongin-Si Gyeonggi-do 17113 (KR)**
• **YOON, Bit Na**
**Yongin-Si Gyeonggi-do 17113 (KR)**
• **LEE, Dong Hee**
**Yongin-Si Gyeonggi-do 17113 (KR)**
• **JUNG, June Hyuk**
**Yongin-Si Gyeonggi-do 17113 (KR)**

(74) Representative: **Marks & Clerk LLP**
**15 Fetter Lane**
**London EC4A 1BW (GB)**

(54) **QUANTUM DOTS, QUANTUM DOT PREPARATION METHOD, AND ELECTRONIC DEVICE COMPRISING QUANTUM DOTS**

(57) Provided are quantum dots, a preparation method therefor, and an electronic device comprising same, each of the quantum dots comprising a core and a first shell covering at least a part of the core, wherein the core comprises indium (In), a first element and phosphorus (P), the first shell comprises a second element and a third element, the first element and the second element are each independently a group III element, the third element is a group VI element, and inequality 1 is satisfied. <Inequality 1> $(M^1+M^2+M^3)/M^{In} > 7$. In inequality 1, $M^{In}$ is the number of moles of In in the core and the first shell, $M^1$ is the number of moles of the first element in the core and the first shell, $M^2$ is the number of moles of the second element in the core and the first shell, and $M^3$ is the number of moles of the third element in the core and the first shell.

FIG. 1

EP 4 644 509 A1

## Description

### Technical Field

One or more embodiments relate to a quantum dot, a method of preparing the quantum dot, and an electronic apparatus including the quantum dot.

### Background Art

Quantum dots are nano crystals of a semiconductor material and are materials that exhibit a quantum confinement effect. When quantum dots receive light from an excitation source to reach an energy excited state, the quantum dots spontaneously emit energy according to a corresponding energy band gap. In this case, quantum dots of the same material may emit light having different wavelengths depending on the size of the quantum dots. Accordingly, the size of quantum dots may be adjusted to obtain light in a desired wavelength range and exhibit characteristics such as excellent color purity and high luminous efficiency. Therefore, quantum dots are applicable to various devices.

### Disclosure of Invention

### Technical Problem

One or more embodiments include a quantum dot having excellent chemical stability and photoluminescence properties, a method of preparing the quantum dot, and an electronic apparatus including the quantum dot.

### Solution to Problem

According to an aspect,
provided is a quantum dot including a core and a first shell covering at least a portion of the core.
The core includes indium (In), a first element, and phosphorus (P).
The first shell includes a second element and a third element,

the first element and the second element are each independently a Group III element, and
the third element is a Group VI element.

The quantum dot satisfies Inequality 1 below:

$$<\text{Inequality 1}>$$

$$(M^1+M^2+M^3)/M^{In} > 7.$$

In Inequality 1,

$M^{In}$ denotes the number of moles of indium (In) in the core and the first shell,
$M^1$ denotes the number of moles of the first element in the core and the first shell,
$M^2$ denotes the number of moles of the second element in the core and the first shell, and
$M^3$ denotes the number of moles of the third element in the core and the first shell.

According to another aspect, provided is a method of manufacturing a quantum dot, the method including:

providing a first particle including indium (In) and phosphorus (P), and
bringing a first composition into contact with the first particle, wherein
the first composition includes a first precursor including the first element, a second precursor including the second element, and a third precursor including the third element, and
the quantum dot includes a core and a first shell covering at least a portion of the core.

The core includes indium (In), the first element, and P.
The first shell includes a second element and a third element,

**EP 4 644 509 A1**

the first element and the second element are each independently a Group III element, and
the third element is a Group VI element.

The quantum dot satisfies Inequality 1:

$$<\text{Inequality 1}> (M^1+M^2+M^3)/M^{In} > 7.$$

where, in Inequality 1,

$M^{In}$ denotes the number of moles of indium (In) in the core and the first shell,
$M^1$ denotes the number of moles of the first element in the core and the first shell,
$M^2$ denotes the number of moles of the second element in the core and the first shell, and
$M^3$ denotes the number of moles of the third element in the core and the first shell.

According to another aspect, provided is an electronic apparatus comprising the quantum dot.

**Advantageous Effects of Invention**

The quantum dot may satisfy a certain elemental composition and may have excellent chemical stability and photoluminescent properties. In an embodiment, for example, the quantum dot may exhibit excellent blue emission properties.
In addition, in the method of preparing a quantum dot, a core and a shell may be formed at the same time, and accordingly, an emission wavelength of a quantum dot may be easily adjusted. In an embodiment, for example, the method of preparing a quantum dot may be advantageous in shortening the emission wavelength of the quantum dot.
Therefore, a high-quality electronic apparatus may be provided using the quantum dot and/or the method of manufacturing the quantum dot.

**Brief Description of Drawings**

FIG. 1 is a view illustrating a quantum dot according to one embodiment;
FIG. 2 is a schematic view illustrating a structure of an electronic apparatus according to one embodiment;
FIG. 3 is a schematic view illustrating a structure of a light-emitting element according to one embodiment; and
FIG. 4 shows a result of observing quantum dots using a transmission electron microscope ("TEM"), according to one embodiment.

**Best Mode for Carrying out the Invention**

As the present disclosure allows for various changes and numerous embodiments, embodiments will be illustrated in the drawings and described in detail in the written description. The effects and features of the present disclosure and methods of accomplishing the same will become apparent from the following description of the embodiments in detail, taken in conjunction with the accompanying drawings. The present disclosure may, however, be embodied in many different forms and should not be construed as limited to the embodiments set forth herein.
As used herein, the terms "first", "second", and the like do not have limited meaning but are used for the purpose of distinguishing one component from another component.
As used herein, the expressions used in the singular such as "a," "an," and "the" are intended to include the plural forms as well, unless the context clearly indicates otherwise.
It will be understood that the terms such as "including," "comprising," and "having" used herein specify the presence of stated features or components, but do not preclude the presence or addition of one or more other features or components. For example, unless otherwise defined, the terms such as "including," "comprising," and "having" may mean both a case of including only the features or components described in the specification and a case of further including other components.
As used herein, "Group II elements may include Group IIA elements and Group IIB elements in the International Union of Pure and Applied Chemistry ("IUPAC") periodic table, and examples of the Group II elements may include zinc (Zn), cadmium (Cd), mercury (Hg), and copernicium (Cn), but one or more embodiments are not limited thereto.

As used herein, "Group III elements" may include Group IIIA elements and Group IIIB elements in the IUPAC periodic table, and examples of the Group III elements may include aluminium (Al), indium (In), gallium (Ga), thallium (Tl), and nihonium (Nh), but one or more embodiments are not limited thereto.

As used herein, "Group V elements" may include Group VA elements and Group VB elements in the IUPAC periodic table, and examples of the Group V elements may include nitrogen (N), phosphorus (P), and arsenic (As), but one or more embodiments are not limited thereto.

As used herein, "Group VI elements" may include Group VIA elements and Group VIB elements in the IUPAC periodic table, and examples of the Group VI elements may include oxygen (O), sulfur (S), selenium (Se), and tellurium (Te), but one or more embodiments are not limited thereto.

[Quantum dot]

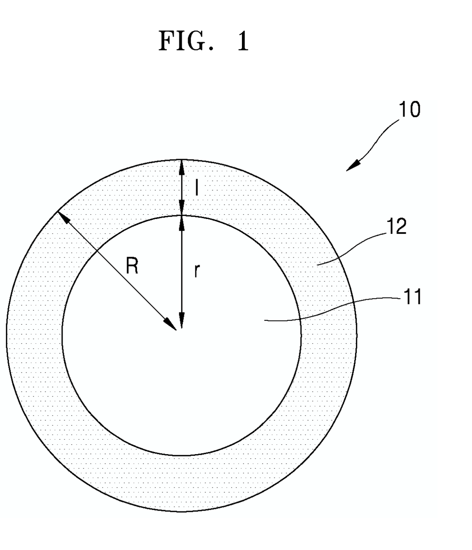

Referring to FIG. 1, a quantum dot 10 according to one embodiment may include a core 11 including indium (In), a first element, and phosphorus (P), and a first shell 12 covering at least a portion of the core 11.

A quantum dot according to one embodiment may include a core and a first shell covering at least a portion of the core.

The core may include indium (In), a first element, and phosphorus (P).

The first shell may include a second element and a third element.

The first element and the second element may each independently be a Group III element,

The third element may be a Group VI element.

The quantum dot satisfies Inequality 1 below:

<Inequality 1>

$$(M^1 + M^2 + M^3)/M^{In} > 7.$$

In Inequality 1 above,

$M^{In}$ denotes the number of moles of indium (In) in the core and the first shell,
$M^1$ denotes the number of moles of the first element in the core and the first shell,
$M^2$ denotes the number of moles of the second element in the core and the first shell, and
$M^3$ denotes the number of moles of the third element in the core and the first shell.

In the quantum dot according to one embodiment, regarding an elemental composition of Inequality 1, that is, a value, which is obtained by dividing the sum of the numbers of moles of the first element, the second element, and the third element in the core and the first shell by the number of moles of indium (In), may be greater than about 7. Accordingly, the quantum dot may exhibit excellent chemical stability and photoluminescent properties. In an embodiment, for example, the quantum dot may exhibit excellent blue emission properties.

According to one embodiment, the quantum dot may satisfy Inequality 1-1 below:

<Inequality 1-1>

$$10 \leq (M^1 + M^2 + M^3)/M^{In} \leq 50.$$

In Inequality 1-1 above,

$M^{In}$ denotes the number of moles of indium (In) in the core and the first shell,
$M^1$ denotes the number of moles of the first element in the core and the first shell,
$M^2$ denotes the number of moles of the second element in the core and the first shell, and
$M^3$ denotes the number of moles of the third element in the core and the first shell.

According to one embodiment, the quantum dot may satisfy Inequality 2 below:

<Inequality 2>

$$0.5 < (M^1+M^2)/M^3 < 1.5.$$

In Inequality 2 above,

> $M^1$ denotes the number of moles of the first element in the core and the first shell,
> $M^2$ denotes the number of moles of the second element in the core and the first shell, and
> $M^2$ denotes the number of moles of the third element in the core and the first shell.

In the quantum dot according to one embodiment, regarding an elemental composition of Inequality 2, that is, a value, which is obtained by dividing the sum of the numbers of moles of the first element and the second element in the core and the first shell by the number of moles of the third element, may be greater than about 0.5 and less than about 1.5. Accordingly, the quantum dot may exhibit excellent chemical stability and photoluminescent properties. In an embodiment, for example, the quantum dot may exhibit excellent blue emission properties.
According to one embodiment, the quantum dot may satisfy Inequality 2-1 below:

<Inequality 2-1>

$$0.7 ≤ (M^1+M^2)/M^3 ≤ 1.3.$$

In Inequality 2-1 above,

> $M^1$ denotes the number of moles of the first element in the core and the first shell,
> $M^2$ denotes the number of moles of the second element in the core and the first shell, and
> $M^3$ denotes the number of moles of the third element in the core and the first shell.

According to one embodiment, the first element may be In, Ga, or Al.
According to one embodiment, the core may further include a fourth element.
According to one embodiment, the fourth element may be a Group III element.
According to one embodiment, the first element may be different from the fourth element.
According to one embodiment, the core may include an alloy of indium (In), the first element, the fourth element, and phosphorus (P).
According to one embodiment, the core may include InP, InGaP, InAlP, InGaAlP, or a combination thereof.
According to one embodiment, a diameter (2r) of the core may be in a range of about 0.5 nanometers (nm) to about 10 nm. In an embodiment, for example, the diameter of the core may be in a range of about 0.1 nm to about 5 nm or a range of about 0.5 nm to about 0.5 nm, for example, in a range of about 0.6 nm to about 2.4 nm, a range of about 0.75 nm to about 2.25 nm, or a range of about 1 nm to about 2 nm.
According to one embodiment, the second element may be In or Ga.
According to one embodiment, the third element may be S.
According to one embodiment, the first shell may further include a fifth element.
According to one embodiment, the fifth element may be a Group II element or a Group III element.
According to one embodiment, the first shell may include a Group III-VI compound, a Group II-III-VI compound, or a combination thereof.
Examples of the III-VI compound may include a binary element compound such as $InS$, $InS_2$, $InS$, $InS_2$, $GaO_2$, $GaS_2$, or $AlO_2$, or a combination thereof.
Examples of the Group II-III-VI compound may include a ternary element compound $CdGaS$, $CdGaSe$, $CdGa_2Se_3$, $CdGaTe$, $CdInS$, $CdInSe$, $CdIn_2S_3$, $CdIn_2Se_3$, $CdInTe$, $ZnGaS$, $ZnGaSe$, $ZnGa_2Se_3$, $ZnGaTe$, $ZnInS$, $ZnInSe$, $ZnIn_2S_3$, $ZnIn_2Se_3$, $ZnInTe$, $HgGaS$, $HgGaSe$, $HgGa_2Se_3$, $HgGaTe$, $HgInS$, $HgInSe$, $HgIn_2S_3$, $HgIn_2Se_3$, or $HgInTe$, a quaternary element compound such as $CdInGaS_3$, $CdInGaSe_3$, $ZnInGaS_3$, $ZnInGaSe_3$, $HgInGaS_3$, or $HgInGaSe_3$, or a combination thereof.
According to one embodiment, the first shell may include $GaS_x$ (where x is a real number greater than 0 and less than or equal to 3), $In_2S_3$, $InGaS_3$, $ZnGaS$, or a combination thereof.
According to one embodiment, a thickness (I) of the first shell may be in a range of about 0.1 nm to about 5 nm. In an embodiment, for example, the thickness of the first shell may be in a range of about 0.2 nm to about 4 nm, a range of about 0.2 nm to about 3 nm, a range of about 0.4 nm to about 2 nm, or a range of about 0.5 nm to about 1 nm.

When the thickness of the first shell satisfies the above-described range, an emission wavelength of the quantum dot may be adjusted. In an embodiment, for example, when the thickness of the first shell satisfies the above-described range, an emission wavelength of the quantum dot may be effectively prevented from being lengthened.

According to one embodiment, the first element of the core may be identical to the second element of the first shell.

According to one embodiment, the quantum dot may include a second shell covering at least a portion of the first shell.

According to one embodiment, the second shell may include a sixth element and a seventh element.

According to one embodiment, the sixth element may be a Group II element, a Group III element, or a Group IV element.

According to one embodiment, the seventh element may be a Group V element or a Group VI element.

According to one embodiment, the second shell may include an alloy of the sixth element and the seventh element.

According to one embodiment, the second shell may include a Group II-VI compound, a Group III-V compound, a Group III-VI compound, a Group I-III-VI compound, a Group II-III-VI compound, a II-IV-V Group compound, a Group II-V compound, a Group IV-V compound, or a combination thereof.

Examples of the II-VI compound may include a binary element compound such as CdS, CdSe, CdTe, ZnS, ZnSe, ZnTe, ZnO, HgS, HgSe, HgTe, MgSe, or MgS, a ternary element compound such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS, a quaternary element compound such as CdZnSeS, CdZnSeTe, CdZnSTe, CdHgSeS, CdHgSeTe, CdHgSTe, HgZnSeS, HgZnSeTe, HgZnSTe, or a combination thereof.

Examples of the III-V Group compound may include a binary element compound such as GaN, GaP, GaAs, GaSb, AlN, AlP, AlAs, AlSb, InN, InP, InAs, InSb, a ternary element compound such as GaNP, GaNAs, GaNSb, GaPAs, GaPSb, AlNP, AlNAs, AlNSb, AlPAs, AlPSb, InGaP, InNP, InAlP, InNAs, InNSb, InPAs, or InPSb, a quaternary element compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, or InAlPSb, or a combination thereof. The Group III-V compound may further include a Group II element. Examples of a Group II-III-V compound further including a Group II element may include InZnP, InGaZnP, InAlZnP, and the like.

For examples of the Group III-VI compound, reference may be made to those described herein.

Examples of the Group I-III-VI compound may include a ternary element compound such as AgInS, $AgInS_2$, CuInS, $CuInS_2$, $CuGaO_2$, $AgGaO_2$, or $AgAlO_2$, or a combination thereof.

For examples of the Group I-III-VI compound, reference may be made to those described herein.

Examples of the Group II-IV-V compound may include $ZnSnP_2$, $ZnSnAs_2$, $ZnSnSb_2$, and the like.

Examples of the Group II-V compound may include ZnP, ZnAs, ZnSb, and the like.

Examples of the IV-VI Group compound may include a binary element compound such as SnS, SnSe, SnTe, PbSe, PbS, or PbTe, a ternary element compound such as SnSeS, SnSeTe, SnSTe, SnPbS, SnPbSe, SnPbTe, PbSTe, PbSeS, or PbSeTe, a quaternary element compound such as SnPbSSe, SnPbSeTe, or SnPbSTe, or a combination thereof.

According to one embodiment, the second shell may include ZnS, ZnSe, ZnTe, ZnO, ZnSeS, ZnSeTe, ZnSTe, or a combination thereof.

According to one embodiment, a thickness of the second shell may be in a range of about 0.1 nm to about 5 nm. In an embodiment, for example, the thickness of the second shell may be in a range of about 0.2 nm to about 4 nm, a range of about 0.2 nm to about 3 nm, a range of about 0.4 nm to about 2 nm, or a range of about 0.5 nm to about 1 nm.

According to one embodiment, a diameter (2R) of the quantum dot may be in a range of about 1 nm to about 15 nm. In an embodiment, for example, the diameter of the quantum dot may be in a range of about 1 nm to about 12 nm or a range of about 1 nm to about 10 nm.

According to one embodiment, the quantum dot may not include cadmium. Accordingly, the quantum dot may not have a problem due to the high toxicity of cadmium.

According to one embodiment, the quantum dot may have a maximum emission wavelength of about 200 nm to about 800 nm.

According to one embodiment, the quantum dot may be configured to emit blue light having a maximum emission wavelength of about 410 nm to about 490 nm.

According to one embodiment, the quantum dot may be configured to emit deep blue light having a maximum emission wavelength of about 410 nm to about 465 nm.

According to one embodiment, the quantum dot may have a roundness of about 0.7 to about 0.9.

According to one embodiment, a shape of the quantum dot is not particularly limited and may be a shape commonly used in the art. In an embodiment, for example, the quantum dot may have a spherical shape, a pyramidal shape, or a multi-arm shape or may be in the form of a cubic nanoparticle, a nanotube, a nanowire, a nanofiber, a nanoplatelet particle, or the like.

According to one embodiment, a full width of half maximum ("FWHM") of a photoluminescence ("PL") of the quantum dot may be about 60 nm or less, for example, about 55 nm or less, about 50 nm or less, or about 40 nm or less. When the FWHM of the quantum dot satisfies the above-described range, color purity and color reproducibility may be excellent, and a wide viewing angle may be effectively improved.

According to one embodiment, the quantum dot may have a quantum yield of about 70% or more, for example, about 80% or more or about 90% or more.

According to one embodiment, the quantum dot may have a quantum yield of about 70% or more, for example, about 80% or more or about 90% or more after being purified with ethanol.

[Method of preparing quantum dot]

A method of preparing a quantum dot may be a method of preparing a quantum dot including a core and a first shell covering at least a portion of the core,

where the core includes indium (In), a first element, and phosphorus (P),
the first shell includes a second element and a third element,
the first element and the second element are each independently a Group III element,
the third element is a Group VI element, and
the quantum dot satisfies Inequality 1:

$$\text{<Inequality 1>}$$

$$(M^1 + M^2 + M^3)/M^{In} > 7.$$

In Inequality 1 above,

$M^{In}$ denotes the number of moles of indium (In) in the core and the first shell,
$M^1$ denotes the number of moles of the first element in the core and the first shell,
$M^2$ denotes the number of moles of the second element in the core and the first shell, and
$M^3$ denotes the number of moles of the third element in the core and the first shell.

The method of preparing a quantum dot according to one embodiment may include

providing a first particle including In and P, and
bringing a first composition into contact with the first particle, where
the first composition includes a first precursor including the first element, a second precursor including the second element, and a third precursor including the third element.

According to one embodiment, the providing of the first particle including In and P may include reacting a precursor including indium (In) with a precursor including phosphorus (P).

According to one embodiment, the precursor including indium (In) may be indium, an indium compound, or a combination thereof.

In an embodiment, for example, the precursor including indium (In) may be indium, indium acetate, indium chloride, indium oxide, indium nitrate, indium sulfate, indium carboxylate, or a combination thereof.

According to one embodiment, the precursor including phosphorus (P) may be phosphorus, a phosphorus compound, or a combination thereof.

In an embodiment, for example, the precursor including phosphorus (P) may be alkyl phosphine, tris(trialkylsilyl) phosphine, tris(dialkylsilyl) phosphine, tris(dialkylamino) phosphine, or a combination thereof.

According to one embodiment, the first particle may further include a fourth element. For a description of the fourth element, reference may be made to those described herein.

According to one embodiment, the providing of the first particle including In, P, and the fourth element includes reacting a precursor including indium (In), a precursor including phosphorus (P), and a precursor including the fourth element with each other.

According to one embodiment, the precursor including the fourth element may be a precursor including a Group III element.

According to one embodiment, the precursor including the Group III element may be aluminium or an aluminium compound, gallium or a gallium compound; indium or an indium compound, or thallium or a thallium compound.

In an embodiment, for example, the precursor including the Group III element may be aluminium phosphate, aluminium acetylacetonate, aluminium chloride, aluminium fluoride, aluminium oxide, aluminium nitrate, aluminium sulfate, gallium acetylacetonate, gallium chloride, gallium fluoride, gallium oxide, gallium nitrate, gallium sulfate, gallium acetate, indium acetate, indium chloride, indium oxide, indium nitrate, indium sulfate, indium carboxylate, or the like.

According to one embodiment, the first particle may include an alloy of In, P, and the fourth element.

According to one embodiment, the first particle may include InP, InGaP, InAlP, or a combination thereof.

According to one embodiment, the first particle may have a maximum emission wavelength of about 410 nm to about 520 nm.

According to one embodiment, a diameter of the first particle may be in a range of about 0.5 nm to about 10 nm. In an embodiment, for example, the diameter of the first particle may be in a range of about 0.1 nm to about 5 nm or a range of about 0.5 nm to about 2.5 nm, for example, in a range of about 0.6 nm to about 2.4 nm, a range of about 0.75 nm to about 2.25 nm, or a range of about 1 nm to about 2 nm.

According to one embodiment, the diameter of the first particle may be the same as a diameter of the core. In an embodiment, for example, the diameter of the first particle may remain unchanged in the brining of the first composition into contact with the first particle.

The first composition may include the first precursor, the second precursor, and the third precursor.

According to one embodiment, the first precursor and the second precursor may each independently be a precursor including a Group III element.

According to one embodiment, for a description of the precursor including the Group III element, reference may be made to those described herein.

According to one embodiment, the third precursor may be a precursor including a Group VI element.

According to one embodiment, the precursor including the Group VI element may be sulfur or a sulfur compound, selenium or a selenium compound, or tellurium or a tellurium compound.

In an embodiment, for example, the precursor including the Group VI element may be sulfur, a sulfur compound, or a combination thereof.

In an embodiment, for example, the precursor including the Group VI element may be sulfur, S-oleylamine, trialkylphosphine sulfide, trialkenylphosphine sulfide, alkylamino sulfide, alkenylamino sulfide, alkylthiol, selenium, trialkylphosphine selenide, trialkenylphosphine selenide, alkylamino selenide, alkenylamino selenide, trialkylphosphine telluride, trialkenylphosphine telluride, alkylamino telluride, alkenylamino telluride, or the like.

According to one embodiment, the third precursor may be sulfur, S-oleylamine, trialkylphosphine sulfide, trialkenylphosphine sulfide, alkylamino sulfide, alkenylamino sulfide, or a combination thereof.

According to one embodiment, in the method of preparing a quantum dot, the first element may be identical to the second element.

According to one embodiment, in the method of manufacturing a quantum dot, the first precursor may be identical to the second precursor.

According to one embodiment, through the bringing of the first composition into contact with the first particle, indium (In) included in the first particle and the first element included in the first precursor may undergo a cation exchange reaction to form a core including indium (In), the first element, and phosphorus (P).

In an embodiment, for example, when the first particle is InP and the first element included in the first precursor is Ga, In in the first particle and Ga included in the first precursor may be configured to exchange cations to form a core including InGaP.

According to one embodiment, the first shell covering at least a portion of the core may be formed through the bringing of the first composition into contact with the first particle.

According to one embodiment, through the bringing of the first composition into contact with the first particle, indium (In) included in the first particle and the first element included in the first precursor may undergo a cation exchange reaction to form the core and simultaneously form the first shell covering at least a portion of the core.

In the method of preparing a quantum dot, since the core and the first shell may be simultaneously formed through a single operation of bringing the first composition into contact with the first particle, there may be an advantage in terms of a process, and an emission wavelength may be easily controlled.

According to one embodiment, a quantum dot prepared according to the method of preparing a quantum dot may have a maximum emission wavelength of about 200 nm to about 800 nm.

In an embodiment, for example, the emission wavelength of the quantum dot may be shortened through a cation exchange reaction between indium (In) included in the first particle and the first element included in the first precursor, and when the first shell is formed, a thickness may be adjusted to prevent the emission wavelength from being lengthened. Accordingly, the method of preparing a quantum dot may be advantageous in shortening the emission wavelength of the quantum dot.

According to one embodiment, the quantum dot prepared according to the method of preparing a quantum dot may be configured to emit blue light having a maximum emission wavelength of about 410 nm to about 490 nm.

According to one embodiment, the quantum dot prepared according to the method of preparing a quantum dot may be configured to emit deep blue light having a maximum emission wavelength of about 410 nm to about 465 nm.

According to one embodiment, the bringing of the first composition into contact with the first particle may be performed at a temperature of about 150 degrees in Celsius (°C) to about 330 °C.

According to one embodiment, the bringing of the first composition into contact with the first particle may be performed within about 150 minutes after the first composition is injected into the first particle. In an embodiment, for example, the quantum dot may be prepared immediately when the first composition is brought into contact with the first particle at a temperature of about 150 °C to about 330 °C, or the quantum dot may be prepared when, after the first composition is brought into contact with the first particle, a temperature of about 150 °C to about 330 °C is maintained for a time of about 150 minutes or less. According to one embodiment, the bringing of the first composition into contact with the first particle may be performed within about 120 minutes after the first composition is injected into the first particle.

According to one embodiment, the method of manufacturing a quantum dot may further include forming a second shell covering the first shell. For a description of the second shell, reference may be made to those described herein.

The forming of the second shell may be performed through a wet chemical process, an organometallic chemical vapor deposition process, a molecular beam epitaxy process, or a process similar thereto, but one or more embodiments are not limited thereto.

In the wet chemical process, a precursor material is mixed with an organic solvent to grow a quantum dot particle crystal. When the quantum dot particle crystal grows, the organic solvent naturally serves as a dispersant coordinated on a surface of the quantum dot particle crystal and adjusts the growth of the quantum dot particle crystal so that the growth of quantum dot particles may be controlled through a process which is more easily performed at low costs as compared with a vapor deposition method such as metal organic chemical vapor deposition ("MOCVD") or molecular beam epitaxy ("MBE").

According to one embodiment, the forming of the second shell may be performed using a second composition which includes a precursor including the sixth element and a precursor including the seventh element.

According to one embodiment, the precursor including the sixth element may be a precursor including a Group II element, a precursor including a Group III element, a precursor including a Group IV element, or a combination thereof.

According to one embodiment, the precursor including the Group II element may be zinc or a zinc compound, cadmium or a cadmium compound, or mercury or a mercury compound.

In an embodiment, for example, the precursor including the Group II element may be zinc acetate, dimethyl zinc, diethyl zinc, zinc carboxylate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulphate, cadmium oxide, dimethyl cadmium, diethyl cadmium, cadmium carbonate, cadmium acetate dihydrate, cadmium acetylacetonate, cadmium fluoride, cadmium chloride, cadmium iodide, cadmium bromide, cadmium perchlorate, cadmium phosphide, cadmium nitrate, cadmium sulfate, cadmium carboxylate, mercury iodide, mercury bromide, mercury fluoride, mercury cyanide, mercury nitrate, mercury perchlorate, mercury sulfate, mercury oxide, mercury carbonate, mercury carboxylate, or the like.

For a description of the precursor including the Group III element, reference may be made to those described herein.

According to one embodiment, the precursor including the seventh element may be a Group V element, a Group VI element, or a combination thereof.

According to one embodiment, the precursor including the Group V element is nitrogen or a nitrogen compound, phosphorus or a phosphorus compound, or arsenic or an arsenic compound.

In an embodiment, for example, the precursor including the Group V element may be alkyl phosphine, tris(trialkylsilyl) phosphine, tris(dialkylsilyl) phosphine, tris(dialkylamino) phosphine, tris(trimethylsilyl)phosphine ("TMSP"), arsenic oxide, chloride arsenic, arsenic sulfate, arsenic bromide, arsenic iodide, nitric oxide, a nitric acid, ammonium nitrate, or the like.

For a description of the precursor including the Group VI element, reference may be made to those described herein.

According to one embodiment, the method of manufacturing a quantum dot may further include surface-treating the quantum dot with an organic ligand or a metal halide.

According to one embodiment, the organic ligand may include a $C_4$-$C_{30}$ fatty acid.

In an embodiment, for example, the organic ligand may include a palmitic acid, a palmitoleic acid, a stearic acid, an oleic acid, trioctylphosphine ("TOP"), TOP oxide, oleylamine, octylamine, trioctylamine, hexadecylamine, octanethiol, dodecanethiol, a hexylphosphonic acid, a tetradecylphosphonic acid, an octylphosphonic acid, or the like.

According to one embodiment, the metal halide may be a metal halide represented by Formula 10 below:

<Formula 10>

$$A^{m+}(X^-)_m.$$

In Formula 10 above,

A$^{m+}$ is a metal cation of valency m, m is 1, 2, 3, or 4, and
X$^-$ is a halide ion.

According to one embodiment, the metal halide may be zinc halide, indium halide, aluminium halide, gallium halide, or a combination thereof.

According to one embodiment, the metal halide may be $ZnCl_2$, $InCl_3$, $AlCl_3$, $GaCl_3$, $NaCl$, $ZnI_2$, $AlI_3$, $GaI_3$, or a combination thereof.

According to one embodiment, the first composition and/or the second composition may further include a ligand, a solvent, or a combination thereof.

According to one embodiment, the ligand may include a palmitic acid, a palmitoleic acid, a stearic acid, an oleic acid, TOP, TOP oxide, oleylamine, octylamine, trioctylamine, hexadecylamine, octanethiol, dodecanethiol, a hexylphosphonic acid, a tetradecylphosphonic acid, an octylphosphonic acid, or the like.

According to one embodiment, the solvent included in the first composition and/or the second composition may be an organic solvent. In an embodiment, for example, the solvent may include 1-octadecene ("ODE"), trioctylamine ("TOA"), TOP, or a combination thereof.

[Electronic apparatus]

According to one embodiment, an electronic apparatus including the quantum dot is provided.

The quantum dot may be included in various electronic apparatuses. In an embodiment, for example, the electronic apparatus including the quantum dot may be a light-emitting apparatus, an authentication apparatus, or the like.

The electronic apparatus (for example, a light-emitting apparatus or a display apparatus) may further include a light-emitting element, and i) a color filter, ii) a color conversion layer, or iii) a color filter and a color conversion layer. The color filter and/or the color conversion layer may be disposed in at least one traveling direction of light emitted from the light-emitting element. In an embodiment, for example, light emitted from the light-emitting element may be blue light or white light. According to one embodiment, the light-emitting element may include a quantum dot. According to one embodiment, the color conversion layer may include a quantum dot. The quantum dot may be, for example, the quantum dot described herein.

The electronic apparatus may be applied to various displays, a light source, an illuminator, a personal computer (for example, a mobile personal computer), a mobile phone, a digital camera, an electronic notebook, an electronic dictionary, an electronic game machine, a medical apparatus (for example, an electronic thermometer, a blood pressure monitor, a blood glucose meter, a pulse measuring apparatus, a pulse wave measuring apparatus, an electrocardiogram display apparatus, an ultrasonic diagnostic apparatus, or an endoscope display apparatus), a fish detector, various measuring apparatuses, instruments (for example, instruments for vehicles, aircrafts, or ships), a projector, or the like.

According to one embodiment, the electronic apparatus may include an optoelectronic device including the quantum dot.

The optoelectronic device may be a photovoltaic device, a photodiode, a phototransistor, a photomultiplier, a photo resistor, a photo detector, a light sensitive detector, a solid-state triode, a battery electrode, a light-emitting device, a light-emitting diode ("LED"), an organic light-emitting element, a quantum dot light-emitting diode ("QLED"), a transistor, a solar cell, a laser, or a diode injection laser.

According to one embodiment, there may be provided an electronic apparatus 200 including a light source 220, and a color conversion member 230 disposed on a path of light emitted from the light source 220, where a quantum dot 10 is included in the color conversion member 230.

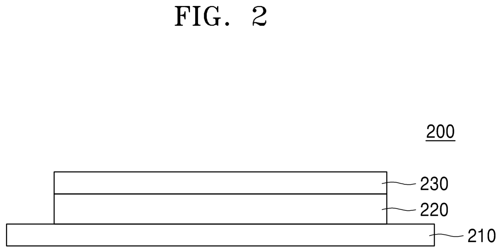

FIG. 2 is a schematic view illustrating a structure of the electronic apparatus 200 according to the embodiment. The electronic apparatus 200 of FIG. 2 may include a substrate 210, the light source 220 disposed on the substrate 210, and the color conversion member 230 disposed on the light source 220.

In an embodiment, for example, the light source 220 may be a back light unit ("BLU") used in a liquid crystal display ("LCD"), a fluorescent lamp, a light-emitting element, an organic light-emitting element, a QLED, or a combination thereof. The color conversion member 230 may be disposed in at least one traveling direction of light emitted from the light source 220.

At least one region of the color conversion member 230 of the electronic apparatus 200 may include the quantum dot, and the region may be configured to absorb light emitted from the light source 220 to emit blue light having a maximum emission wavelength ranging from about 410 nm to about 490 nm.

In this case, the fact that the color conversion member 230 is disposed in at least one traveling direction of light emitted from the light source 220 does not exclude that other elements may be further included between the color conversion member 230 and the light source 220.

In an embodiment, for example, a polarizing plate, a liquid crystal layer, a light guide plate, a diffusion plate, a prism sheet, a micro lens sheet, a luminance enhancing sheet, a reflective film, a color filter, or a combination thereof may be disposed between the light source 220 and the color conversion member 230.

As another example, a polarizing plate, a liquid crystal layer, a light guide plate, a diffusion plate, a prism sheet, a micro lens sheet, a luminance enhancing sheet, a reflective film, a color filter, or a combination thereof may be additionally disposed on the color conversion member 230.

The light source may be a BLU used in an LCD, a fluorescent lamp, an LED, an organic light-emitting element (organic light-emitting diode (OLED), or a QLED but is not limited thereto.

Light emitted from the light source as described above may be photo-converted while passing through the quantum dot 10. In an embodiment, for example, the quantum dot 10 may be configured to absorb first light emitted from the light source and may be configured to emit visible light different from the first light. In an embodiment, for example, the quantum dot 10 may be configured to absorb ultraviolet ("UV") light emitted from the light source and may be configured to emit visible light having a maximum emission wavelength of about 410 nm to about 750 nm. For another example, the quantum dot 10 may be configured to absorb blue light emitted from the light source and may be configured to emit visible light having a maximum emission wavelength of about 495 nm to about 750 nm. Accordingly, the quantum dot 10 or the color conversion member including the quantum dot 10 may be designed to absorb UV light or blue light emitted from the light source and emit wavelengths in various color ranges.

For still another example, the quantum dot 10 may be configured to absorb blue light emitted from the light source and may be configured to emit green light having a maximum emission wavelength of about 495 nm to about 570 nm. As yet another example, the quantum dot 10 may be configured to absorb blue light emitted from the light source and may be configured to emit red light having a maximum emission wavelength of about 630 nm to about 750 nm.

Accordingly, the quantum dot 10 or the color conversion member including the quantum dot 10 may be configured to absorb light emitted from the light source to implement a blue, green, or red color with high luminance and high color purity.

The electronic apparatus 200 shown in FIG. 2 may be an example of an apparatus according to the embodiment, may have various known forms, and may further include various known components for this purpose.

According to another embodiment, the electronic apparatus may have a structure in which a light source, a light guide plate, a color conversion member, a first polarizing plate, a liquid crystal layer, a color filter, and a second polarizing plate are sequentially disposed.

According to still another embodiment, the electronic apparatus may have a structure in which a light source, a light guide plate, a first polarizing plate, a liquid crystal layer, a second polarizing plate, and a color conversion member are sequentially disposed.

In the above embodiments, the color filter may include a pigment or dye. In the above embodiments, one of the first polarizing plate and the second polarizing plate may be a vertical polarizing plate, and the other may be a horizontal polarizing plate.

As described herein, a quantum dot may be used as an emitter. Therefore, according to another embodiment, there may be provided an electronic apparatus including a light-emitting element including a first electrode, a second electrode facing the first electrode, and an emission layer disposed between the first electrode and the second electrode, where the quantum dot is included in the light-emitting element (for example, the emission layer of the light-emitting element). The light-emitting element may further include a hole transport region disposed between the first electrode and the emission layer, an electron transport region disposed between the emission layer and the second electrode, or a combination thereof.

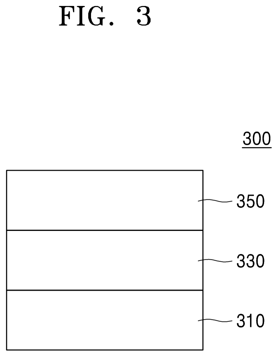

FIG. 3 is a schematic cross-sectional view illustrating a light-emitting element 300 according to one embodiment of the present disclosure. The light-emitting element 300 may include a first electrode 310, an intermediate layer 330, and a second electrode 350.

The intermediate layer 330 may be disposed on the first electrode 310. The intermediate layer 330 may include an emission layer.

The intermediate layer 330 may further include a hole transport region disposed between the first electrode 310 and the emission layer and an electron transport region disposed between the emission layer and the second electrode 350.

In addition to the quantum dot 10, the intermediate layer 330 may further include a metal-containing compound such as an organometallic compound, various organic materials, and the like.

The hole transport region and the electron transport region may include a hole transport material and/or an electron transport material commonly used in an organic light-emitting element.

The intermediate layer 330 may include i) two or more light-emitting units sequentially stacked between the first electrode 310 and the second electrode 350 and ii) a charge generation layer disposed between the two light-emitting units. When the intermediate layer 330 includes the light-emitting unit and the charge generation layer as described above, the light-emitting element 300 may be a tandem light-emitting element.

The emission layer may be a single quantum dot layer or may have a structure in which two or more quantum dot layers are stacked. In an embodiment, for example, the emission layer may be a single quantum dot layer or may have a multilayer structure in which 2 to 100 quantum dot layers are stacked.

The emission layer may include the quantum dot described herein.

In addition to the quantum dot described herein, the emission layer may further include different quantum dots.

In addition to the quantum dot described herein, the emission layer may further include a dispersion medium in which the quantum dots are dispersed in a naturally coordinated form. The dispersion medium may include an organic solvent, a polymer resin, or a combination thereof. As the dispersion medium, any transparent medium may be used as long as the transparent medium does not affect the optical performance of the quantum dot, does not change or reflect light, and does not cause light absorption. In an embodiment, for example, the organic solvent may include toluene, chloroform, ethanol, octane, or a combination thereof, and the polymer resin may include an epoxy resin, a silicone resin, a polystyrene resin, an acrylate resin, or a combination thereof.

The emission layer may be formed by applying an emission layer-forming composition including a quantum dot onto the hole transport region and volatilizing at least a portion of a solvent included in the emission layer-forming composition.

In an embodiment, for example, water, hexane, chloroform, toluene, octane, or the like may be used as the solvent included in the emission layer-forming composition.

The emission layer-forming composition may be applied using spin coating, casting, micro-gravure coating, gravure coating, bar coating, roll coating, wire bar coating, dip coating, spray coating, screen printing, flexographic printing, offset printing, inkjet printing, or the like.

When the light-emitting element 300 is a full-color light-emitting element, the emission layer may include emission layers that emit light having different colors for each subpixel.

In an embodiment, for example, the emission layer may be patterned into a first color emission layer, a second color emission layer, and a third color emission layer for each subpixel. In this case, at least one emission layer among the above-described emission layers may include a quantum dot. Specifically, the first color emission layer may be a quantum dot emission layer including a quantum dot, and the second color emission layer and the third color emission layer may be organic emission layers each including an organic compound. Here, first to third colors are different colors, and specifically, pieces of light having the first to third colors may have different maximum emission wavelengths. The first to third colors may be combined with each other to become a white color.

As another example, the emission layer may further include a fourth color emission layer, and variously modifications are possible in which at least one of the first to fourth color emission layers may be a quantum dot emission layer including a quantum dot, and the remaining emission layers may be organic emission layers each including an organic compound. Here, first to fourth colors are different colors, and pieces of light having the first to fourth colors may have different maximum emission wavelengths. The first to fourth colors may be combined with each other to become a white color.

Alternatively, the light-emitting element 300 may have a structure in which two or more emission layers configured to emit light having the same or different colors are stacked to be in contact with or spaced apart from each other. Various modifications are possible in which at least one emission layer of the two or more color emission layers may be a quantum dot emission layer including a quantum dot, and the remaining emission layers may be organic emission layers each including an organic compound. Specifically, the light-emitting element 300 may include a first color emission layer and a second color emission layer, where a first color and a second color may be the same color or different colors. More specifically, both the first color and the second color may be blue colors.

In addition to the quantum dot, the emission layer may further include at least one selected from an organic compound and a semiconductor compound.

Specifically, the organic compound may include a host and a dopant. The host and the dopant may include a host and a dopant commonly used in an organic light-emitting element.

Specifically, the semiconductor compound may be an organic and/or inorganic perovskite.

In addition to a light-emitting element, an electronic apparatus (for example, a light-emitting apparatus) may further include i) a color filter, ii) a color conversion layer, or iii) a color filter and a color conversion layer. The color filter and/or the color conversion layer may be disposed in at least one traveling direction of light emitted from the light-emitting element. In an embodiment, for example, light emitted from the light-emitting element may be blue light or white light. For a description of the light-emitting element, reference may be made to those described above. According to one embodiment, the color conversion layer may include a quantum dot. The quantum dot may be, for example, the quantum dot described herein.

The electronic apparatus may include a first substrate. The first substrate may include a plurality of subpixel regions, the color filter may include a plurality of color filter regions corresponding to the plurality of subpixel regions, respectively, and the color conversion layer may include a plurality of color conversion regions corresponding to the plurality of subpixel regions, respectively.

A pixel defining layer may be disposed between the plurality of subpixel regions to define each subpixel region.

The color filter may further include a plurality of color filter regions and light blocking patterns disposed between the plurality of color filter regions, and the color conversion layer may further include a plurality of color conversion regions and light blocking patterns disposed between the plurality of color conversion regions.

The plurality of color filter regions (or the plurality of color conversion regions) may include a first region configured to emit first color light, a second region configured to emit second color light, and/or a third region configured to emit third color light, and the first color light, the second color light, and/or the third color light may have different maximum emission wavelengths. In an embodiment, for example, the first color light may be red light, the second color light may be green light, and the third color light may be blue light. In an embodiment, for example, the plurality of color filter regions (or the plurality of color conversion regions) may include quantum dots. Specifically, the first region may include a red quantum dot, the second region may include a green quantum dot, and the third region may not include a quantum dot. For a description of the quantum dot, reference may be made to those described herein. Each of the first region, the second region, and/or the third region may further include a scatterer.

In an embodiment, for example, the light-emitting element may be configured to emit first light, the first region may absorb the first light to emit first-first color light, the second region may be configured to absorb the first light to emit second-first color light, and the third region may be configured to absorb the first light to emit third-first color light. In this case, the first-first color light, the second-first color light, and the third-first color light may have different maximum emission wavelengths. Specifically, the first light may be blue light, the first-first color light may be red light, the second-first color light may be green light, and the third-first color light may be blue light.

The electronic apparatus may further include a thin film transistor in addition to the light-emitting element described above. The thin film transistor may include a source electrode, a drain electrode, and an active layer, and any one of the source electrode and the drain electrode may be electrically connected to any one of a first electrode and a second electrode of the light-emitting element.

The thin film transistor may further include a gate electrode, a gate insulating film, and the like.

The active layer may include crystalline silicon, amorphous silicon, an organic semiconductor, an oxide semiconductor, or the like.

The electronic apparatus may further include an encapsulation unit configured to seal the light-emitting element. The encapsulation unit may be disposed between the color filter and/or color conversion layer and the light-emitting element. The encapsulation unit may allow light from the light-emitting element to be emitted to the outside and concurrently may block external air and moisture from permeating into the light-emitting element. The encapsulation unit may be an encapsulation substrate including a transparent glass substrate or a plastic substrate. The encapsulation unit may be a thin film encapsulation layer including at least one of an organic layer and/or an inorganic layer. When the encapsulation unit is the thin film encapsulation layer, the electronic apparatus may be flexible.

In addition to the color filter and/or the color conversion layer, various functional layers may be additionally disposed on the encapsulation unit according to the use of the electronic apparatus. Examples of the functional layer may include a touch screen layer, a polarization layer, and the like. The touch screen layer may be a resistive touch screen layer, a capacitive touch screen layer, or an infrared touch screen layer. An authentication apparatus may be, for example, a biometric authentication apparatus that identifies an individual using biometric information (for example, a fingertip, a pupil, or the like).

The authentication apparatus may further include a biometric information collecting unit, in addition to the light-emitting element described above.

The electronic apparatus may be applied to various displays, a light source, an illuminator, a personal computer (for example, a mobile personal computer), a mobile phone, a digital camera, an electronic notebook, an electronic dictionary, an electronic game machine, a medical apparatus (for example, an electronic thermometer, a blood pressure monitor, a blood glucose meter, a pulse measuring apparatus, a pulse wave measuring apparatus, an electrocardiogram display apparatus, an ultrasonic diagnostic apparatus, or an endoscope display apparatus), a fish detector, various measuring apparatuses, instruments (for example, instruments for vehicles, aircrafts, or ships), a projector, or the like.

Hereinafter, a quantum dot and a method of preparing the same according to one embodiment of the present disclosure will be described in more detail with reference to Examples.

**[Examples]**

**Comparative Example 1: Preparation of InP quantum dots**

5 mmol of indium acetate, 15 mmol of a lauric acid, 2.5 mmol of zinc acetate, 2.5 mmol of oleylamine, and 80 ml of 1-octadecene as solvent were mixed and degassed at a temperature of 120 °C.

4.3 ml of a mixed solution (volume ratio of 1:4) of TMSP and TOP was injected into the resultant mixture under a nitrogen ($N_2$) atmosphere at a temperature of 50 °C, heated to a temperature to 250 °C, and reacted for 20 minutes. Thereafter, a temperature was decreased to room temperature to terminate the reaction, and a reaction product was purified using acetone as an anti-solvent and dispersed in toluene to prepare InP quantum dots.

**Examples 1 to 5: Preparation of InGaP/GaS$_x$ quantum dots**

1 ml of the InP quantum dots dispersed in toluene and prepared in Comparative Example 1, 2.3 mmol of gallium chloride ($GaCl_3$) dissolved in toluene, and 1.6 mmol of a sulfur-oleylamine (S-oleylamine) mixture were each injected into 8 ml of oleylamine degassed at a temperature to 120 °C under a nitrogen atmosphere, heated to a temperature to 240 °C, and then reacted for reaction times shown in Table 1 to prepare InGaP/GaS$_x$ quantum dots of Examples 1 to 4.

0.5 ml of TOP and 0.5 ml of octanethiol were additionally injected into the InGaP/GaS$_x$ quantum dots of Example 4, reacted at a temperature to 200 °C for 20 minutes, surface-treated, purified using acetone as an anti-solvent, and dispersed in toluene to prepare InGaP/GaS$_x$ quantum dots of Example 5.

**Evaluation Example 1**

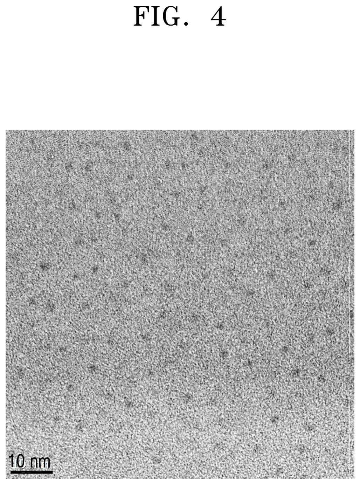

The quantum dots prepared in Example 5 were observed using a transmission electron microscope (TEM). A result thereof is shown in FIG. 4.

In addition, a maximum emission wavelength (λmax) was evaluated on each of the quantum dots prepared in Examples 1 to 5 and Comparative Example 1. Results thereof are shown in Table 1.

A measurement method is as follows: for a 1 mg/L solution of quantum dots, a maximum emission wavelength was evaluated by analyzing a PL spectrum measured using a PL spectrometer.

[Table 1]

| No. | Quantum dots | Reaction time (@240 °C) | TOP surface treatment | λmax (@365 nm ex.) |
|---|---|---|---|---|
| Comparative Example 1 | InP | - | X | 489 nm |
| Example 1 | InGaP/GaS$_x$ | 0 minutes | X | 432 nm |
| Example 2 | InGaP/GaS$_x$ | 30 minutes | X | 436 nm |
| Example 3 | InGaP/GaS$_x$ | 60 minutes | X | 442 nm |
| Example 4 | InGaP/GaS$_x$ | 120 minutes | X | 443 nm |
| Example 5 | InGaP/GaS$_x$ | 120 minutes | O | 445 nm |

Referring to Table 1, it was seen that an emission wavelength of quantum dots according to one embodiment could be easily adjusted. In particular, it could be seen that the maximum emission wavelengths of the quantum dots of Examples 1 to 5 were shortened as compared with the InP quantum dots of Comparative Example 1 and were suitable for deep blue emission. Here, @240 °C means that the reaction time is measured at 240 °C.

**Examples 6 to 9 and Comparative Example 2: Preparation of InGaP/GaS$_x$ quantum dots**

As shown in Table 2, InGaP/GaS$_x$ quantum dots of Examples 6 to 9 and Comparative Example 2 were prepared in the same manner as in Example 1, except that an $(M^{Ga}+M^S)/M^{In}$ ratio was adjusted. $M^{Ga}$ denotes the number of moles of Gallium (Ga) in included in the quantum dots, $M^S$ denotes the number of moles of Sulfur (S) included in the quantum dots, and $M^{In}$ denotes the number of moles of indium (In) included in the quantum dots.

**Examples 10 to 12 and Comparative Examples 3 and 4: Preparation of InGaP/GaS$_x$ quantum dots**

As shown in Table 3, InGaP/GaS$_x$ quantum dots of Examples 10 to 12 and Comparative Examples 3 and 4 were prepared in the same manner as in Example 1, except that an $M^{Ga}/M^S$ ratio was adjusted. $M^{Ga}$ denotes the number of moles of Ga included in the quantum dots, and $M^S$ denotes the number of moles of S included in the quantum dots.

**Evaluation Example 2**

A maximum emission wavelength ($\lambda$max) was evaluated on each of the quantum dots prepared in Examples 1 to 12 and Comparative Examples 2 to 4. Results thereof are shown in Tables 2 and 3.

A measurement method is as follows: for a 1 mg/L solution of quantum dots, a maximum emission wavelength was evaluated by analyzing a PL spectrum measured using a PL spectrometer.

[Table 2]

|  | $(M^{Ga}+M^S)/M^{In}$ | $\lambda_{max}$(@365 nm ex.) |
|---|---|---|
| Comparative Example 2 | 7 | Non-emission |
| Example 6 | 10 | 435 nm |
| Example 7 | 32 | 445 nm |
| Example 8 | 40 | 452 nm |
| Example 9 | 50 | 460 nm |

[Table 3]

|  | $M^{Ga}/M^S$ | $\lambda_{max}$(@365 nm ex.) |
|---|---|---|
| Comparative Example 3 | 0.5 | Non-emission |
| Example 10 | 0.7 | 460 nm |
| Example 11 | 1.11 | 445 nm |
| Example 12 | 1.3 | 430 nm |
| Comparative Example 4 | 1.5 | Non-emission |

Referring to Tables 2 and 3, it was seen that an emission wavelength of quantum dots according to one embodiment could be easily adjusted. In particular, it was seen that the maximum emission wavelengths of the quantum dots of Examples 6 to 12 were shortened and suitable for deep blue emission.

**Claims**

1. A quantum dot comprising:

a core; and
a first shell covering at least a portion of the core,
wherein the core comprises indium (In), a first element, and phosphorus (P),
the first shell comprises a second element and a third element,
the first element and the second element are each independently a Group III element, and the third element is a Group VI element,
wherein the quantum dot satisfies Inequality 1 below:

<Inequality 1>

$$(M^1+M^2+M^3)/M^{In} > 7,$$

wherein, in Inequality 1,

$M^{In}$ denotes a total number of moles of indium (In) in the core and the first shell,
$M^1$ denotes a total number of moles of the first element in the core and the first shell,
$M^2$ denotes a total number of moles of the second element in the core and the first shell, and
$M^3$ denotes a total number of moles of the third element in the core and the first shell.

2. The quantum dot of claim 1, wherein the quantum dot satisfies Inequality 2 below:

<Inequality 2>

$$0.5 < (M^1+M^2)/M^3 < 1.5,$$

in Inequality 2,

$M^1$ denotes the number of moles of the first element in the core and the first shell,
$M^2$ denotes the number of moles of the second element in the core and the first shell, and
$M^3$ denotes the number of moles of the third element in the core and the first shell.

3. The quantum dot of claim 1, wherein the first element is gallium (Ga) or aluminium (Al), the second element is gallium (Ga), and the third element is sulfur (S).

4. The quantum dot of claim 1, wherein the first element is identical to the second element.

5. The quantum dot of claim 1, wherein the core further comprises a fourth element, the fourth element is a Group III element, and the first element is different from the fourth element.

6. The quantum dot of claim 1, wherein the first shell comprises a Group III-VI compound, a Group II-III-VI compound, or a combination thereof.

7. The quantum dot of claim 1, wherein the first shell comprises GaS, $In_2S_3$, $InGaS_3$, ZnGaS, or a combination thereof.

8. The quantum dot of claim 1, wherein the first shell has a thickness of about 0.1 nanometers (nm) to about 5 nm.

9. The quantum dot of claim 1, further comprising a second shell covering at least a portion of the first shell, wherein the second shell comprises a sixth element and a seventh element, the sixth element is a Group II element, a Group III element, or a Group IV element, and the seventh element is a Group V element or a Group VI element.

10. The quantum dot of claim 9, wherein the second shell comprises a Group II-VI compound, a Group III-V compound, a Group III-VI compound, a Group I-III-VI compound, a Group II-III-VI compound, a II-IV-V Group compound, a Group II-V compound, a Group IV-V compound, or a combination thereof.

11. The quantum dot of claim 1, wherein the quantum dot emits blue light having a maximum emission wavelength of about 410 nm to about 465 nm.

12. A method of manufacturing a quantum dot, the method comprising:

providing a first particle comprising indium (In) and phosphorus (P); and
bringing a first composition into contact with the first particle,
wherein the first composition comprises a first precursor comprising a first element, a second precursor comprising a second element, and a third precursor comprising a third element, and
the quantum dot comprises a core and a first shell covering at least a portion of the core,
wherein the core includes indium (In), a first element, and phosphorus (P),
the first shell includes a second element and a third element,
the first element and the second element are each independently a Group III element, and
the third element is a Group VI element,
wherein the quantum dot satisfies Inequality 1:

<Inequality 1> $(M^1+M^2+M^3)/M^{In} > 7,$

wherein, in Inequality 1,

$M^{In}$ denotes a total number of moles of indium (In) in the core and the first shell,
$M^1$ denotes a total number of moles of the first element in the core and the first shell,

16

M$^2$ denotes a total number of moles of the second element in the core and the first shell, and
M$^3$ denotes a total number of moles of the third element in the core and the first shell.

13. The method of claim 12, wherein, through the bringing of the first composition into contact with the first particle, indium (In) included in the first particle and the first element included in the first precursor undergo a cation exchange reaction to form the core.

14. The method of claim 12, wherein, through the bringing of the first composition into contact with the first particle, the first shell covering the at least a portion of the core is formed.

15. The method of claim 12, wherein the bringing of the first composition into contact with the first particle is performed within about 150 minutes at a temperature of about 150 degrees in Celsius (°C) to about 330 °C.

16. The method of claim 12, wherein the first element is identical to the second element, and the first precursor is identical to the second precursor.

17. The method of claim 12, further comprising forming a second shell covering the first shell.

18. The method of claim 12, further comprising surface-treating the quantum dot with an organic ligand or a metal halide.

19. An electronic apparatus comprising the quantum dot of claim 1.

20. The electronic apparatus of claim 19, wherein the electronic apparatus comprises an optoelectronic device comprising the quantum dot, and the optoelectronic device is a photovoltaic device, a photodiode, a phototransistor, a photomultiplier, a photo resistor, a photo detector, a light sensitive detector, a solid-state triode, a battery electrode, a light-emitting device, a light-emitting diode, an organic light-emitting element, a quantum dot light-emitting diode, a transistor, a solar cell, a laser, or a diode injection laser.

FIG. 1

# FIG. 2

200

230
220
210

# FIG. 3

300

350

330

310

FIG. 4

## INTERNATIONAL SEARCH REPORT

| International application No. |
| --- |
| **PCT/KR2023/020653** |

| A. | CLASSIFICATION OF SUBJECT MATTER |
| --- | --- |

**C09K 11/70**(2006.01)i; **C09K 11/62**(2006.01)i; **C09K 11/02**(2006.01)i; B82Y 20/00(2011.01)n; B82Y 40/00(2011.01)n

According to International Patent Classification (IPC) or to both national classification and IPC

| B. | FIELDS SEARCHED |
| --- | --- |

Minimum documentation searched (classification system followed by classification symbols)

C09K 11/70(2006.01); C01B 25/08(2006.01); C08K 3/10(2006.01); C09K 11/08(2006.01); C09K 11/55(2006.01); H01L 33/00(2010.01); H01L 33/04(2010.01); H01L 33/30(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 코어(core), 쉘(shell), 양자점(quantum dot), 전자장치(electronic device), 광전자정치(optoelectronic device)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | KR 10-2022-0012827 A (SAMSUNG ELECTRONICS CO., LTD.) 04 February 2022 (2022-02-04) See claims 1-43; and paragraphs [0109]-[0137]. | 1-4,6-20 |
| Y | | 5 |
| Y | KR 10-2022-0030357 A (SAMSUNG DISPLAY CO., LTD. et al.) 11 March 2022 (2022-03-11) See claim 13. | 5 |
| A | KR 10-2021-0122664 A (SAMSUNG DISPLAY CO., LTD. et al.) 12 October 2021 (2021-10-12) See entire document. | 1-20 |
| A | JP 2006-083219 A (SHARP CORP. et al.) 30 March 2006 (2006-03-30) See entire document. | 1-20 |
| A | JP 2020-176043 A (NIPPON CHEM. IND. CO., LTD.) 29 October 2020 (2020-10-29) See entire document. | 1-20 |

| ☐ Further documents are listed in the continuation of Box C. | ☑ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **18 March 2024** | **18 March 2024** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

EP 4 644 509 A1

**INTERNATIONAL SEARCH REPORT**
Information on patent family members

International application No.

**PCT/KR2023/020653**

| Patent document cited in search report | | | Publication date (day/month/year) | Patent family member(s) | | | Publication date (day/month/year) |
|---|---|---|---|---|---|---|---|
| KR | 10-2022-0012827 | A | 04 February 2022 | CN | 113969165 | A | 25 January 2022 |
| | | | | EP | 3943574 | A1 | 26 January 2022 |
| | | | | EP | 3943574 | B1 | 22 March 2023 |
| | | | | US | 11753589 | B2 | 12 September 2023 |
| | | | | US | 2022-0025256 | A1 | 27 January 2022 |
| | | | | US | 2023-0374378 | A1 | 23 November 2023 |
| KR | 10-2022-0030357 | A | 11 March 2022 | CN | 114106812 | A | 01 March 2022 |
| | | | | EP | 3960836 | A1 | 02 March 2022 |
| | | | | US | 2022-0064527 | A1 | 03 March 2022 |
| KR | 10-2021-0122664 | A | 12 October 2021 | CN | 115485351 | A | 16 December 2022 |
| | | | | US | 11802239 | B2 | 31 October 2023 |
| | | | | US | 2021-0301202 | A1 | 30 September 2021 |
| | | | | WO | 2021-201572 | A1 | 07 October 2021 |
| JP | 2006-083219 | A | 30 March 2006 | US | 2006-0158089 | A1 | 20 July 2006 |
| | | | | US | 7560859 | B2 | 14 July 2009 |
| JP | 2020-176043 | A | 29 October 2020 | CN | 113905980 | A | 07 January 2022 |
| | | | | KR | 10-2021-0152053 | A | 14 December 2021 |
| | | | | US | 11692134 | B2 | 04 July 2023 |
| | | | | US | 2022-0195299 | A1 | 23 June 2022 |
| | | | | WO | 2020-213365 | A1 | 22 October 2020 |

Form PCT/ISA/210 (patent family annex) (July 2022)